# EUROPEAN PATENT APPLICATION

(11) **EP 4 539 091 A1**
(43) Date of publication of application: **16.04.2025**
(21) Application number: 23202821.7
(22) Date of filing: 10.10.2023
(51) Int. Cl.: H01J 37/244, H01J 37/28

(54) **ELECTRON-BEAM IMAGING SYSTEM**

(71) Applicant: ASML Netherlands B.V., 5500 AH Veldhoven (NL)
(72) Inventor: WIELAND, Marco, Jan-Jaco, 5500 AH Veldhoven (NL)
(74) Representative: ASML Netherlands B.V.

(57) **Abstract**

The present invention provides an electron-beam imaging system comprising an electron-beam source for generating a primary beam, an optical system for directing and focusing the primary beam onto a sample, and a charge detector for collecting interaction products. The charge detector comprises: a current detection electrode configured to connect to current measurement circuitry, a low atomic mass region comprising a low atomic mass material, and a high atomic mass region comprising a high atomic mass material. The high atomic mass material has a higher atomic mass than the low atomic mass material. The electron-beam imaging system is configured such that during use the low atomic mass region is closer to the sample compared to the high atomic mass region for reducing a second-generation interaction products yield at the charge detector.

## Description

### FIELD

The embodiments provided herein generally relate to an electron-beam imaging system.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment, e.g., inspection and/or measurement, of a surface of a substrate, or other object/material, is an important process during and/or after its manufacture.

Pattern assessment systems with a charged particle beam have been used to inspect objects, for example to detect pattern defects and to measure structural features on such objects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over, or across, the sample surface, secondary electrons can be emitted across the surface of the sample. By collecting these emitted secondary electrons from the sample surface, a pattern assessment system (or assessment tool) may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

The emitted signal particles can generally be collected by a detector which is part of the inspection tool. Such detectors are desirably able to distinguish between backscattered electrons and secondary electrons. However, methods used to repel secondary electrons may result in generation of second-generation interaction products at the detector. The second-generation interaction products may reduce a net current measured by the detector, meaning the backscattered electrons are not accurately detected. It is therefore desirable to reduce second-generation interaction product yield whilst still distinguishing between backscattered electrons and secondary electrons.

### SUMMARY

It is an object of the present disclosure to provide embodiments of an electron-beam imaging system.

According to a first aspect of the invention, there is provided an electron-beam imaging system comprising an electron-beam source for generating a primary beam, an optical system for directing and focusing the primary beam onto a sample, and a charge detector for collecting interaction products. The charge detector comprises: a current detection electrode configured to connect to current measurement circuitry, a low atomic mass region comprising a low atomic mass material, and a high atomic mass region comprising a high atomic mass material. The high atomic mass material has a higher atomic mass than the low atomic mass material. The electron-beam imaging system is configured such that during use the low atomic mass region is closer to the sample compared to the high atomic mass region for reducing a second-generation interaction products yield at the charge detector.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam assessment apparatus.
**FIG. 2** is a schematic diagram illustrating an exemplary multi-beam charged particle assessment system that is part of the exemplary electron beam assessment apparatus of **FIG. 1****.**
**FIG. 3** is a schematic diagram of an exemplary multi-beam charged particle device.
**FIG. 4** is a schematic diagram of a cross-section of a detector assembly.
**FIG. 5** is a schematic diagram of a trans impedance amplifier.
**FIG. 6** is a schematic diagram of a charge detector and sample according to an arrangement.
**FIG. 7** is a schematic diagram of a charge detector and sample according to an arrangement wherein the current detection electrode comprises a high atomic mass material.
**FIG. 8** is a schematic diagram of a charge detector and sample according to an arrangement wherein the charge detector comprises an outer layer.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment systems (such as, or such as comprising, a Scanning Electron Microscope (`SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an assessment apparatus may utilize a single primary electron beam incident on a sample. For high throughput inspection, some of the assessment apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam assessment apparatus can therefore assess, for example inspect, a sample at a much higher speed than a single-beam assessment apparatus.

An implementation of known multi-beam assessment apparatus and systems is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

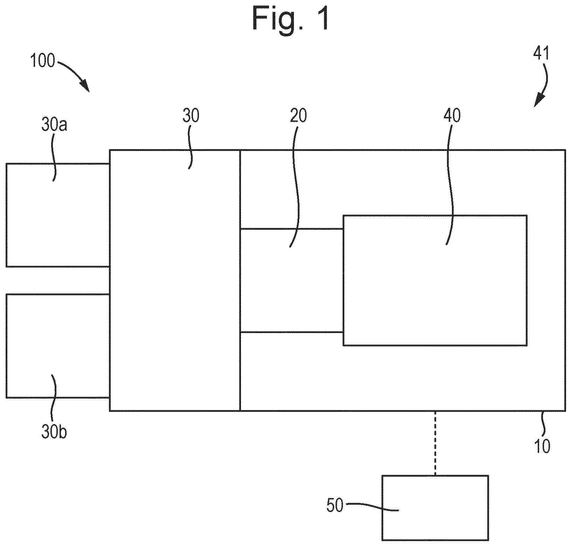

Reference is now made to **FIG. 1****,** which is a schematic diagram illustrating an exemplary charged particle beam assessment apparatus 100. It should be noted that the assessment apparatus comprises part of the assessment system, often the part of the assessment system situated in a fabrication facility. The assessment apparatus may cover a surface area of the fabrication facility floor referred to as an apparatus footprint. The other parts of the assessment system such as service systems of vacuum and fluid supplies and remote processing racks may be located elsewhere in the fabrication facility away from other fabrication systems and apparatus where space is a less significant requirement,

The charged particle beam assessment apparatus 100 of **FIG. 1** includes a main chamber 10, a load lock chamber 20, a charged particle assessment system 40 (which may also be called an electron beam system, electron-beam imaging system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be assessed e.g. measured or inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be assessed. The charged particle assessment system 40 comprises a charged particle device 41. The charged particle device 41 may be an electron-optical device, which may be synonymous with the electron-optical system. The charged particle device 41 may be a multi-beam charged particle device 41 configured to project a multi-beam towards the sample, for example the sub-beams being arranged with respect to each other in a multi-beam arrangement. Alternatively, the charged particle device 41 may be a single beam charged particle device 41 configured to project a single beam towards the sample.

The controller 50 is electronically connected to the charged particle assessment system 40. The controller 50 may be a processor (such as a computer) configured to control the charged particle beam assessment apparatus 100. The controller 50 may also include a processing circuitry configured to execute various signal and image processing functions. While the controller 50 is shown in FIG. 1 as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it can be distributed over at least two of the component elements. While the present disclosure provides examples of the main chamber 10 housing an electron beam assessment apparatus, it should be noted that aspects of the disclosure in their broadest sense are not limited to a chamber housing an electron beam assessment apparatus. Rather, it is appreciated that the foregoing principles may also be applied to other tools and other arrangements of apparatus, that operate under the second pressure.

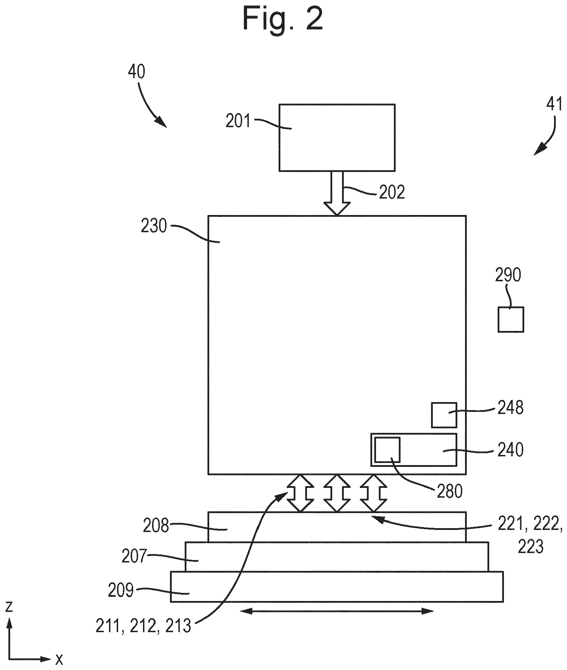

Reference is now made to **FIG. 2****,** which is a schematic diagram illustrating an exemplary charged particle assessment system 40 including a multi-beam charged particle device 41 that is part of the exemplary charged particle beam assessment apparatus 100 of **FIG. 1****.** The multi-beam charged particle device 41 comprises an electron source 201 and a projection apparatus 230. The charged particle assessment system 40 further comprises an actuated stage 209 and a sample holder 207. The sample holder may have a holding surface (not depicted) for supporting and holding the sample. Thus the sample holder may be configured to support the sample. Such a holding surface may be a electrostatic clamp operable to hold the sample during operation of the charged particle device 41 e.g. assessment such as measurement or inspection of at least part of the sample. The holding surface may be recessed into sample holder, for example a surface of the sample holder orientated to face the charged particle device 41. The electron source 201 and projection apparatus 230 may together be referred to as the charged particle device 41. The sample holder 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy < 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2**). However, the signal processing system 280 may be incorporated into any components of the assessment apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle assessment system 40 and charged particle beam assessment apparatus 100 described above, are disclosed in US2020118784, US20200203116, US 2019/0259570 and US2019/0259564 which are hereby incorporated by reference.

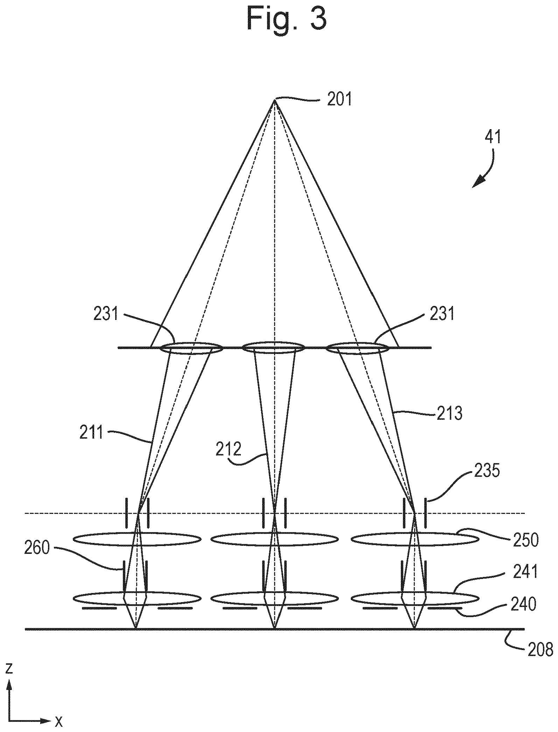

Components of a charged particle assessment system 40 which may be used in the present invention are described below in relation to **FIG. 3** which is a schematic diagram of a charged particle assessment system 40. The charged particle assessment system 40 of **FIG. 3** may correspond to the charged particle assessment system 40 (which may also be referred to as an apparatus or a tool) mentioned above.

The electron source 201 directs electrons toward an array of condenser lenses 231 (otherwise referred to as a condenser lens array). The electron source 201 is desirably a high brightness emitter arranged to operate within an optimized electron-optical performance range that is a compromise between brightness and total emission current (such a compromise may be considered to be a 'good' compromise'). The electron source emits a source beam. There may be many tens, many hundreds or many thousands, or even tens of thousands of condenser lenses 231. The condenser lenses 231 may comprise multi-electrode lenses and have a construction based on EP1602121A1, which document is hereby incorporated by reference in particular to the disclosure of a lens array to split a source beam into a plurality of sub-beams. An most up beam plate, which may be referred to as beam limiting aperture array, and which may be the most up beam plate of the condenser lens array, may generate the plurality of beams. The array condenser lenses (which may comprise the beam limiting aperture array) may provide a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens 231 in the array directs electrons into a respective sub-beam 211, 212, 213 which is focused at a respective intermediate focus downbeam of the condenser lens array. The sub-beams diverge with respect to each other. In an embodiment, deflectors 235 are provided at the intermediate focuses. The deflectors 235 are positioned in the sub-beam paths at, or at least around, the position of the corresponding intermediate points of focus. The deflectors 235 are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Downbeam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. In an embodiment of the arrangement, the collimator may comprise a macro collimator, instead of, or in addition to the deflectors 235. The macro-collimator may be electrostatic for example as two more planar plates with a single aperture.

Below (i.e. downbeam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching an objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. In an embodiment the control lenses of the control lens array may be considered to be part of the objective lenses of the objective lens array. The electrode plates of the control lens array may be considered electron-optically to be additional electrode plates of the objective lens array.

It is desirable to use the control lens array 250 to determine the landing energy. However, it is possible to use in addition the objective lens array 241 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned upbeam of the objective lens array 241.

The control lens array 250 comprises a control lens for each sub-beam 211, 212, 213. A function of the control lens array 250 is to optimize the beam opening angle with respect to the demagnification of the beam and/or to control the beam energy delivered to the objective lens array 241 which directs the sub-beams 211, 212, 213 onto the sample 208. The objective lens array 241 may be positioned at or near the base of the charged particle device 41. The control lens array 250 is optional, but is preferred for optimizing a sub-beam upbeam of the objective lens array. In an arrangement the control lens array 250 may be considered to be part of the objective lens array. The plates of the control lens array may be considered to be additional plates of the objective lens array. Within an objective lens array meeting this definition the function of the control lens array may be a function of the objective lens array in addition to the functions of the objective lens array herein described.

For ease of illustration, lens arrays are depicted schematically herein by arrays of oval shapes (as shown in **FIG. 3**). Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

An array of scan deflectors 260 may be provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

The schematic diagram of an exemplary charged particle device, as shown in **FIG. 3** has an objective lens array assembly. The objective lens array assembly comprises the objective lens array 241. The objective lens array 241 comprises a plurality of objective lenses. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam or group of sub-beams in the multi-beam. Each plate defines a plurality of apertures (which may also be referred to as holes). The position of each aperture in a plate corresponds to the position of a corresponding aperture (or corresponding hole) in the other plate (or plates). The corresponding apertures define the objective lenses and each set of corresponding holes therefore operates in use on the same sub-beam or group of sub-beams in the multi-beam. Each objective lens projects a respective sub-beam of the multi-beam onto a sample 208.

The objective lens array assembly further comprises the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams. (e.g. apply a focusing action to the sub-beams prior to the sub-beams reaching the objective lens array 241). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations. In an embodiment, the control lens array may be considered to be part of the objective lens array.

In the arrangement of **FIG. 3****,** the objective lens array assembly comprises the scan-deflector array 260. The scan-deflector array 260 comprises a plurality of scan deflectors. The scan-deflector array 260 may be formed using MEMS manufacturing techniques. Each scan deflector scans a respective sub-beam over, or across, the sample 208. The scan-deflector array 260 may thus comprise a scan deflector for each sub-beam. Each scan deflector may deflect rays in the sub-beam in one direction (e.g. parallel to a single axis, such as an X axis) or in two directions (e.g. relative to two nonparallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. The scan-deflector array 260 is positioned between the objective lens array 241 and the control lens array 250. In the embodiment shown, the scan-deflector array 260 is provided instead of a macro scan deflector, such as an electrostatic scan deflector (not shown). A scan-deflector array 260 may be more spatially compact than a macro scan deflector.

The objective lens array assembly may comprise a detector 240. (Alternatively the detector maybe comprised in the charged particle device 41 without having to be present in the objective lens array assembly).

The detector 240 may be positioned between the objective lens array 241 and the sample 208. The detector 240 is configured to be the most down-beam feature of the electron-optical device, for example proximate the sample 208. The detector 240 may be very close to the sample 208, for example less than 5mm, 3mm, 1.5 mm, 300 µm, preferably between 200 and 10 µm, more preferably between 100 and 30 µm, for example between 40 and 70 µm.

The detector 240 may be positioned in the device so as to face the sample 208. Alternatively or additionally, the detector 240 may be positioned elsewhere in the electron-optical system 41 such that part of the electron-optical device that faces the sample 208 is other than, and thus is not, a detector; such as an electrode of the objective lens arrangement In such an arrangement another element of the electron-optical device may face the sample during operation, for example an electrode plate of the objective lens. In all these arrangements there is a most downbeam element of the electron-optical system, such as detector 240, most proximate to the sample. The most downbeam surface of the most downbeam element may face the sample. The most downbeam surface may be referred to as a facing surface.

A bottom surface of the detector 240 (or a facing surface of the detector 240 which may face a sample 208 in use, may comprise a substrate on which are provided a plurality of detector elements. Each detector element may surround a beam aperture. The beam apertures may be formed by etching through the substrate. In the arrangement the beam apertures are in a hexagonal close packed array, or alternatively in a rectangular array. The detector elements may be arranged in a rectangular array or a hexagonal array.

In cross section of the detector, the detector elements form the bottommost, i.e. most close to the sample 208, surface of the detector 240. Between the detector elements and the main body of the substrate a logic layer may be provided. At least part of the signal processing system may be incorporated into the logic layer. A wiring layer is provided on the backside of, or within, the substrate and connected to the logic layer by through-substrate vias. The wiring layer can include control lines, data lines and power lines. A printed circuit board and/or other semiconductor chips may be provided on, for example connected to, the backside of detector 240.

The detector 240 may be implemented by integrating a CMOS chip detector into an electrode of the objective lens array 241, such as the bottom electrode of the objective lens array 241. Integration of a detector 240 into the objective lens array 241 or other component of the electron-optical system 41 allows for the detection of electrons emitted in relation to multiple respective sub-beams. The CMOS chip may embody the detector it may be orientated to face the sample. In an embodiment, detector elements to capture the secondary charged particles are formed in the surface metal layer of the CMOS device. The detector elements can be formed in other layers. Power and control signals of the CMOS may be connected to the CMOS by the through-silicon vias. A passive silicon substrate with holes shields the CMOS chip from high E-fields, for example providing robustness.

In order to maximize the detection efficiency it is desirable to make the surface of the detector elements as large as possible, so that substantially all the area of the objective lens array 240 (excepting the apertures) is occupied by detector elements. Additionally or alternatively, each detector element has a diameter substantially equal to an array pitch (i.e. of the pitch of the apertures of the aperture array in the electrodes of the objective lens assembly 241). The diameter of each detector element may be less than approximately 600 µm, and preferably between approximately 50 µm and 500 µm. The pitch may be selected depending on the intended distance between the sample 208 and the detector 240. In an embodiment the outer shape of the detector element is a circle, but this can be made a square to maximize the detection area. The diameter of the through-substrate via can be minimized. A typical size of the electron beam is in the order of 5 to 15 µm.

In an embodiment, a single detector element surrounds each beam aperture. In another embodiment, a plurality of detector elements are provided around each beam aperture.

In some embodiments for example of any of the embodiments described with reference to and shown in **FIG. 3****,** one or more aberration correctors are provided that reduce one or more aberrations in the sub-beams. The one or more aberration correctors may be provided in any of the embodiments, e.g. as part of the charged particle-optical device, and/or as part of an optical lens array assembly, and/or as part of an assessment system, and/or as part of an electron-optical arrangement. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, the objective lens array 241. In an embodiment, these aberration correctors reduce one or more of the following: field curvature; focus error; and astigmatism. Additionally or alternatively, one or more scanning deflectors (not shown) may be integrated with, or directly adjacent to, the objective lens array 241 for scanning the sub-beams 211, 212, 213 over the sample 208. In an embodiment, the scanning deflectors described in US 2010/0276606, which document is hereby incorporated by reference in its entirety, may be used.

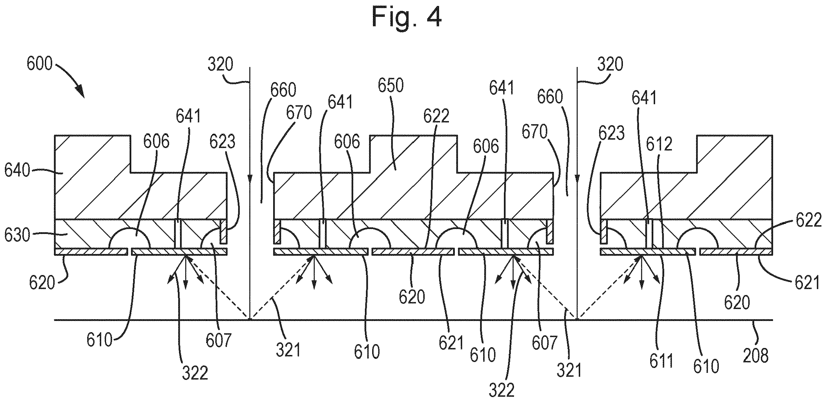

An exemplary version of a detector assembly is shown in **FIG. 4** which is described in detail below. **FIG. 4** shows a cross section through the detector assembly. The detector assembly 600 may be used as detector array 240, for example as shown in **FIGs 2-3****.** The detector assembly may be used for a charged particle assessment apparatus, although the detector assembly can be provided without other components.

The detector assembly 600 may comprise detection elements 610 configured to detect signal particles. Any appropriate types of detector may be used for the detection element 610 as described in further detail below. At least one, multiple, or all the detection elements 610 may comprise multiple portions (i.e. may be a zoned detector element). A detector element 610 may be in the form of one or two or more layers. The layers or at least the surface is preferably metal.

The detector assembly 600 may comprise shield elements 620 for shielding elements within the detector assembly 600. Each shield element 620 may have a surface that is stepped relative to the beam path which may be in the form of one or two or more layers. The layers or at least the surface is preferably metal. Any appropriate metal may be used, e.g. aluminum, copper, etc.. Although multiple shield elements 620 and detection elements 610 are shown in **FIG. 4** and described herein, only a single shield element 620 and a single detection element 610 may be provided.

The detection elements 610 each have a major surface 611 which may be configured to be exposed to signal particles (shown by dashed arrows) emitted from the sample 208. The major surface 611 may be the first surface contacted by the signal particles. The major surface 611 of the detection elements interacts with signal particles and through which signal particles can be detected by the detection element 610. The major surface 611 of the detection element may be a detection surface. The major surface 611 of each of the detection elements 610 provides an outer (i.e. outwardly facing) surface of each detection element 610. Each detection element 610 also has an inner surface 612 facing an opposing direction to the major surface 611 (i.e. the outer surface).

The shield elements 620 each have an outer (i.e. outwardly facing) surface 621. Each shield element 620 may also have an inner surface 622 facing an opposing direction to the outer surface 621. Preferably, the inner surface 622 faces and is in contact with other elements of the detector arrangement, such as an isolating element 630 as shown in the arrangement shown in **FIG. 4****,** and/or a circuit layer.

The electrode elements, i.e. the detection elements 610 and the shield elements 620, may be arranged in a two-dimensional array. In particular, the major surfaces of the electrode elements may be arranged in a two-dimensional array. The two-dimensional array may be facing towards the sample support. The two-dimensional array may be formed in a plane which may be visible in plan view, i.e. which is substantially orthogonal to the sub-beams.

Preferably, the electrode elements, i.e. the detection elements 610 and the shield elements 620, are part of, or within, the structure of the detector assembly, which is preferably a planar detector assembly structure.

The detector assembly 600 may be positioned in the path of the charged particle beam(s). For example, the major surfaces of the electrode elements may be substantially orthogonal to the charged particle beam path 320. For example, the detector assembly 600 may be positioned such that the sub-beams pass through, or adjacent to, the electrode elements of the detector assembly 600.

Each detection element 610 may be provided adjacent to at least part of a shield element 620. Between one of the detection elements 610 and an adjacent shield element 620 is a recess 606. The recess 606 extends from the gap between adjacent electrode elements. An opening of the recess 606 in the major surface is defined between the adjacent electrode elements. The recess is recessed relative to the major surfaces 611 of the electrode elements. The recess 606 therefore replaces the surface between adjacent electrodes of the major surface on which contamination may otherwise be deposited. The recess 606 provides a cavity in which the isolating surface may be positioned remote from the major surface, for example, within the substrate, e.g. so that observation from the sample of the isolating surface is occluded by other features of the detector assembly. The recess 606 in the present embodiment may be non-linear, further improving the effect of the cavity, so that the isolated surface is outside the straight-line path of a signal particle from the sample surface. The chances of a signal particle reaching the isolating surface is reduced compared to an isolating surface directly bridging two electrodes in the major surface.

The detector assembly 600 may have a main body 650. The main body 650 may be formed as a substrate. Different component parts of the detector assembly 600 may be formed as layers of the substrate 650 for example using semiconductor fabrication processes, and/or may be attached together. At least part of a surface of the main body 650 of the detector assembly 600 may be part of the recessed surface.

The detector assembly 600 may additionally comprise the isolating element 630. The isolating element 630 may be configured to support the electrode elements. The isolating element 630 may be configured to support at least the shield element 620. The shield element 620 may be positioned on the isolating element 630. At least part of the isolating element 630 may be configured to support the detection element 610. The detection element 610 may be positioned on the part of the isolating element 630. Preferably, the isolating element 630 is one or more layers. The isolating element 630 may be made of any appropriate material, e.g. SiO2, which may optionally be doped or porous.

The detector assembly 600 may comprise detector circuitry which may be connected to the detection element 610. The detector assembly 600 may comprise a circuitry layer 640 comprising detector circuitry which is in electrical communication with the detection element 610. The circuitry layer 640 may comprise some, if not all, of the circuitry used to process the signals from the detection elements 610. Thus, the circuitry layer 640 may convert the detected signal particles into electrical signals. The circuitry layer 640 may comprise various different electrical components. The circuitry layer 640 may be connected to the detection elements 610. The circuitry layer 640 may comprise parallel layers of circuitry for connecting to each of the detection elements 610. Alternatively, the circuitry layer 640 may comprise a single layer with circuitry adjacent in cross-section for connecting to each of the detection elements 610.

The circuitry layer 640 may be electrically connected to the detection element 610. For example, the detector assembly 600 may comprise electrical conductors 641 (which may be any electrical connector e.g. vias) so as to electrically connect the detection element 610 to detector circuitry. The electrical conductors 641 are for the detector assembly 600 to detect a signal particles through connection to the detection element 610. The circuitry layer 640 may be electrically connected to the detection element 610 through the isolating element 630. The electrical conductors 641 may extend through the shield element 620 and the isolating element 630. Specifically, the electrical conductors 641 may extend through the portion of the shield 620 which is positioned between the detection element 610 and the isolator element 630. Specifically, the electrical conductors 641 may extend through the isolating element 630 which is positioned between the detection element 610 and the shield element 620. Alternatively, the electrical conductors 641 may extend through the isolating element 630 without extending through the shield element 620 (because the shield element is not positioned between the detection element 610 and the isolating element 630), for example, as shown in **FIG 4****.**

Different arrangements are possible and the electrical conductors 641 may only extend through components between the detection element 610 and the relevant part of the detector circuitry.

Additionally or alternatively, detector circuitry and/or wiring may be positioned within or as part of various components of the detector assembly 600. For example, at least part of the detector circuitry may be positioned in the isolating element 630.

Preferably, the isolating element 630 is provided as multiple layers which can be provided between conducting layers of the detector circuity in which electronic elements are provided. The layers of isolating element 630 can electronically insulate the different conducting layers. The conducting layers can be in electrical communication with each other via specific electrical conductors 641 as described above, e.g. vias.

Preferably, an aperture 660 is defined in the detector assembly 600 for the passage of the charged particle beam (i.e. the primary beam or sub-beam). The electrode elements may be arranged around the aperture 660. At least one detection element 610 may be associated with the aperture 660. The detection element 610 may be arranged around the aperture 660. The detection element 610 may define a corresponding aperture 660. In this case, the detection element 610 may surround the aperture 660, which may be beneficial for providing improved detection efficiency.

A single detection element 610 may correspond to each aperture, e.g. as a ring-shaped detection element 610. Alternatively, the at least one detection element 610 may comprise a plurality of detection elements 610 around a respective aperture 660. If the detection element 610 is a zoned detector element, the recess 606 may be provided between each of the zoned portions. Thus, the recessed surface 606 may be laterally recessed around at least one edge of each of the zoned portion. Preferably, the recessed surface 606 is laterally recessed around multiple, or all, edges of each zoned portion.

Although it may be beneficial to have the detection elements 610 surround a respective aperture such that signal particles can be captured by the detection element 610 all the way round the primary beam, other configurations may also be used and the detection element may be formed in any appropriate shape. The aperture 660 may be used for the passage of a single beam or multiple charged particle beams (i.e. a group of charged particle beams). If multiple primary beams (e.g. sub-beams) are provided, then the detector assembly may still be provided to one or both sides, for example, with slits for multiple sub-beam paths.

The detection assembly 600 may define a plurality of apertures 660 as shown in **FIG. 4****.** At least one detection element 610 may be associated with a respective aperture 660, i.e. at least one detection element 610 is provided for each aperture 660. At least one detection element 610 may be associated with a respective charged particle beam. In other words, a detection element 610 may be provided for each primary beam.

The detector assembly 600 may comprise a path shield 623 in at least one of the apertures. The path shield 623 may be configured to shield the detector assembly (i.e. components of the detector assembly) from charged particles through the passageway, and/or for shielding charged particles passing through the passageway. The path shield 623 may be part of the shield electrode 620 or it may be a separate element.

In an arrangement, a cavity 607 extends from the passageway 670. The function of the cavity 607 is similar to the recess, for example to reduce the risk of short-circuiting between the electrode elements such as the detector element 610 and the adjoining electrode element, for example the shield electrode 620. Thus, the cavity 607 may be considered as a variant of the recess 606.

The recess 606 may extend laterally behind each type of electrode element, i.e. behind shield elements 620 and/or detection elements 610 and/or path shields 623 (which may be referred to as a cavity 607). The recessed surface may extend laterally behind both electrode elements adjacent to the recess. The recessed surface may extend laterally behind each (i.e. every) electrode element. The recessed surface 606 may be recessed around a perimeter of each electrode element. Thus, the cavity 607 may also extend laterally behind the path shield 623.

Furthermore, it is described above that the detector assembly 600 comprises a detection element 610 and a shield element 620. However, more generally the detector assembly 600 may comprise a plurality of electrode elements, each electrode element having its own major surface. At least one of the electrode elements is a detection element 610 as described above. At least one of the electrode elements may be a shield element 620 as described above. Preferably the electrode elements comprise exclusively detection elements 610 and shield elements 620.

Although the major surfaces of the electrode elements are preferably provided in a planar surface of the detector assembly 600, alternatively the major surfaces may not be aligned in the same plane. For example, at least some of the major surfaces may be offset, e.g. in the direction of the primary beam path 320, compared to at least one other major surface. Alternatively, the major surfaces may form an acute or obtuse angle with a plane substantially orthogonal to the primary beam path 320. In other words, at least one of the major surfaces may not be coplanar with the sample and/or sample support. The major surfaces may not be coplanar with each other.

The detection element 610 may comprise a single type of detector. In this arrangement, the detection element 610 is a charge detector. The charge detector could be provided as a metal layer, which may be a planar portion. Signal particles with an energy of less than 50 eV (which may correspond to the secondary signal particles described above) can be 'captured' by a charge detector with a relatively small thickness (e.g. of approximately 100 nm or less).

The detection element 610 may comprise at least two or more types of detector, including at least the charge detector. This may be beneficial for detecting different types of signal particles. In this case, the two or more types of detector are preferably layered along the beam path, i.e. the different types of detector are preferably stacked (or layered) in a direction parallel to the beam path 320. Thus, detection surfaces (i.e. major surfaces) of the different detectors may be substantially parallel. The charge detector is preferably provided as a surface layer to other detectors, i.e. the charge detector preferably forms an outermost layer of the detection element 610. Thus, the charge detector may provide the major surface 611 of the detection element 610. Lower energy signal particles may be captured by the charge detector. The vast majority of higher energy signal particles will pass though the charge detector to the other detector(s). Providing a relatively small thickness of the charge detector (e.g. approximately 100 nm or less) is beneficial in allowing signal particles to reach the other detector(s).

The other type of detector may comprise a semiconductor type detector (such as a PIN diode or avalanching photodiode) and/or a scintillating type detector, in addition to the charge detector. The semiconductor and/or scintillating type detector can be used to detect the higher energy signal particles. In the case of a scintillating detector, the signal particles can be converted into photons which may be detected by a photon detector which may or may not be part of the detector assembly 600.

In any of the above embodiment, the collection efficiency may be improved by applying a bias between the sample 208 and the detector assembly 600 to attract the signal particles to the detection elements 610. Thus, a potential may be applied to the detection element 610. Similarly, a potential, which may be the same as applied to the detection elements 610. Typically, the potential of all surfaces facing the substrate (i.e. of the electrode elements) are the same. In practice the bias is preferably applied jointly to all electrode elements of the detector assembly. The potential difference may be referred to as a bias voltage.

The potential may be relatively small. For example, the potential difference between the sample 208 and the detector assembly may be approximately 100 V or less. For example, the potential difference may be approximately -50V to + 300V, or preferably >0V to + 300 V, or preferably +50 V to +300 V. The potential difference between the detector elements 610 and the shield elements 620 to ensure a sufficiently detectable detection signal may be caused by finite gain of the amplifier, which may be of the order of 50 mV. The electrode elements may be more positive than the sample 208. Thus, the potential difference may be used to attract signal particles to the detector assembly. Such an accelerating voltage (e.g. around 50 V - 300V) is small compared the difference in energy between lower energy signal particles (e.g. secondary signal particles with a maximum energy of approximately 50 eV) and higher energy signal particles (e.g. backscatter signal particles with a maximum energy up to the landing energy of keV's or more). It will be noted that a small potential difference will tend to have a greater effect on the lower energy particles, such as those corresponding to the secondary signal particles. Of course, the same potential may be applied to a single detector assembly, e.g. when provided as part of a single beam device.

Although the detector assemblies described above generally include multiple apertures, it will be understood that a single aperture could be provided. The single aperture could be used for the passage there through of a single charged particle beam or multiple charged particle beams. The single aperture may have a single detector element or multiple detector elements.

Certain layers of the electrode elements may be formed at the same level. For example, it is described above that the major surface 621A of the shielding element 620 may be coplanar with the major surface 611 of the detection element 610. In the context of the CMOS structure, this would mean that the layers of each electrode forming these surfaces are provided in the same level of the CMOS structure, which makes them coplanar.

Different types of CMOS process may be used. The material used for the isolating element 630 and/or the portion 631 of the isolating element preferably comprises, or consists of, SiO2. Typically the SiO2 is doped, or porous. Other materials may be used for the isolator, e.g. such as those described in https://en.wikipedia.org/wiki/Low-%CE%BA_dielectric. Preferably, the detector and/or shield elements are made from aluminum. In this case, the fabrication preferably comprises an "aluminum interconnect" process (such as TSMC 180nm). Alternatively (and less preferred), the detector and/or shield elements can be made from copper. In this case, the fabrication method may comprise a CMOS process that uses copper interconnects. Use of copper enables features of smaller dimension.

Material forming the isolating element 630 may be removed to form a lateral recess as described above,. For example, to remove the material forming the isolating element 630 (which is preferably SiO2) in the lateral direction an isotropic etch is preferred. In general, wet etchants etch isotropically. For example, buffered oxide etching (BHF) is a well known etch to etch SiO2, (which is a typical isolator used in CMOS structures, for example, see https://en.wikipedia.org/wiki/Buffered_oxide_etch) and could be used. During such etching steps, the shield element 620 may be beneficial in protecting other components of the detector assembly from the wet etch that is used to remove the isolating material laterally.

In electron beam metrology and inspection different signals can be detected. Typically for high resolution metrology and inspection the secondary electron signal is used. This is because the backscattered electron signal typically gives a worse resolution, and a lower signal. However, the backscattered electron signal may have the advantage of revealing information about structures below the surface of the sample, such as buried defects. As such, it may be desirable to acquire a backscattered electron signal, instead of or in addition to the secondary electron signal.

The backscatter electron signal can be detected using a charge-based detector (referred to herein as a charge detector). In a charge detector the net current falling on the current detection electrode may be measured by a Trans Impedance Amplifier (TIA). In contrast, for example, a PIN detector comprises a reverse-biased PIN diode and has an intrinsic (very lightly doped) semiconductor region sandwiched between a p-doped and an n-doped region. With such a PIN detector, secondary electrons incident on the intrinsic semiconductor region generate electron-hole pairs and allow a current to flow, generating a detection signal. A scintillator comprises a material that emits light when electrons are incident on it. A detection signal is generated by imaging the scintillator with a camera or other imaging device. Unlike the PIN detector and scintillator, the charge detector measures current and is thus independent of the energy of the electrons.

In order to separate the backscatter electron signal from the secondary electron signal, the bias potential between the sample and the detector may be reversed such that secondary electrons originating from the sample are pushed back (away from the detector) to the sample. For example, if the bias potential is 50 V, only electrons with an energy exceeding 50 eV will reach the detector. In this way, secondary electrons having an energy of less than 50 eV may be repelled away from the detector whereas backscattered electrons may still reach the detector. In this way, the secondary electron signal may be distinguished from the backscatter electron signal. With this arrangement, backscattered electrons are directed from the sample 208 to the detector element 610 (as shown by arrows 321 of **FIG. 4**), and these backscattered electrons may result in the generation of further secondary or backscattered electrons emitted from the detector element 610 (as shown by arrows 322 of **FIG. 4**). These further secondary or backscatter electrons emitted from the detector as a result of an incoming backscattered electrons are called second-generation interaction products. The creation of second-generation interaction products may reduce the net current detected by the detector. The second-generation interaction products may also increase the noise level as the number of second-generation interaction products can be subject to Poisson noise.

Another possible disadvantage of the above described arrangement is that the electrode element of the charge detector is commonly made of aluminum. One reason to use aluminum is that this is the material typically used in commercial CMOS processes. If the energy of the backscattered electrons is high, the backscattered electrons may penetrate through this aluminum layer and thus may not be detected. This penetration may be at least reduced, and possibly prevented, by adding a coating having a sufficiently high atomic mass (such as a molybdenum- or tungsten- based coating) on the aluminum electrode element. However, the high atomic mass coating materials have a high backscattered electron yield. As such, the use of the high atomic mass coating may enhance the issues resulting from the generation of second-generation interaction products. It is therefore desirable to provide a detector arrangement able to more effectively distinguish backscattered electron signals from secondary electron signals, with less reduction of net current. In other words, it is desirable to provide a detector arrangement able to more accurately measure backscattered electrons from the sample.

As described above with reference to **FIGs 1-3****,** the electron-beam imaging system 40 comprises an electron-beam source 201 for generating a primary beam, an optical system for directing and focusing the primary beam onto a sample 208, and a detector assembly. The detector assembly may be a detector assembly 600 as described above with reference to **FIG. 4****.** The detector assembly 600 comprises a detection element 610. The detection element 610 is a charge detector, such as the charge detector described above with reference to **FIG. 4****.**

The electron-beam imaging system 40 is desirably configured to create an electric field to repel secondary electrons from the charge detector 610. In particular, the electron-beam imaging system 40 may be configured such that, in a particular operating mode, the secondary electrons are repelled away from the charge detector 610 such that backscattered electrons may be distinguished from secondary electrons. In other words, a current may be detected based on backscattered electrons without secondary electrons contributing significantly to a detected current. In this way, the charge detector 610 may measure a backscatter electron signal.

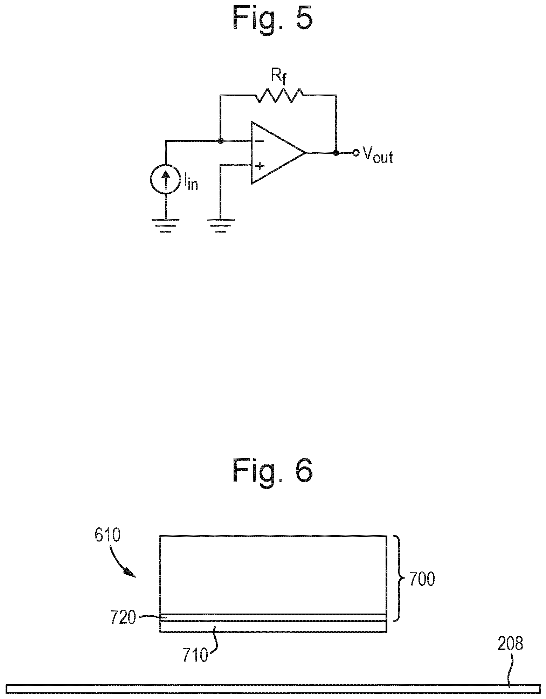

The charge detector 610 comprises a current detection electrode, configured to detect (or collect) backscattered and/or secondary electron current. The backscattered and/or secondary electron current collected by electrode may be connected to current measurement circuitry. The current measurement circuitry is desirably configured to amplify the collected current. The purpose of the amplifier is to enable sufficiently sensitive measurement of the current received or collected by the sensor unit to be measured and thus the number of backscattered and/or secondary electrons. This can be measured by current measurements or the potential difference over a resistor. Several types of amplifier design may be used to amplify backscattered and/or secondary electron current collected by electrode for example a Trans Impedance Amplifier (TIA). In such a TIA, the voltage output of the TIA is equal to the TIA resistance (R_{TIA}) multiplied by the measured current. **FIG. 5** is a schematic diagram of a theoretical TIA in which the voltage output Vₒᵤₜ is simply the product of the measured current Iᵢₙ and the feedback resistance R_{f}.

Arrangements of a charge detector 610 in position facing a sample 208 are provided in **FIGs 6-8****.** As shown in the arrangements of **FIGs 6-8****,** the charge detector 610 comprises a low atomic mass region 710 comprising a low atomic mass material, and a high atomic mass region 720 comprising a high atomic mass material. The high atomic mass material has a higher atomic mass than the low atomic mass material. In other words, the low atomic mass material has a lower atomic mass than the high atomic mass material, such that a second-generation interaction product yield at the charge detector is reduced. In this way, fewer second-generation interaction products are emitted from the detector due to the inclusion of the low atomic mass material than would be generated if the high atomic mass material were present and the low atomic mass material were omitted.

The low atomic mass material may have an atomic mass less than or equal to 16, more desirably less than or equal to 14, yet more desirably less than or equal to 12. For example, the low atomic mass material may be boron, carbon, aluminum, or silicon. The low atomic mass region may comprise one or more low atomic mass materials.

When the charge detector 610 is disposed facing the sample 208, the low atomic mass region 710 is closer to the sample 208 compared to the high atomic mass region 720. In other words, a distance between the low atomic mass region 710 and the sample 208 is less than a distance between the high atomic mass region 720 and the sample 208. With this arrangement, the high atomic mass material may limit a penetration of backscattered electrons through the charge detector 610 (i.e., through the detection element 610). In this way, the likelihood of backscattered electrons passing through the charge detector 610 without being detected is reduced. Furthermore, the low atomic mass material may reduce a backscattered electron yield of the charge detector 610 and thus may reduce a yield of second-generation interaction products. As such, the inclusion of the low atomic mass material may mitigate against an increase in yield of second-generation interaction products which may otherwise result due to the inclusion of the high atomic mass material in the charge detector 610.

The high atomic mass material may have an atomic mass greater than or equal to 18, more desirably greater than or equal to 21, yet more desirably greater than or equal to 24. For example, the high atomic mass material may be molybdenum or tungsten. The high atomic mass region may comprise one or more high atomic mass materials.

As shown in **FIGs 6-8****,** the low atomic mass region 710 is desirably disposed between the high atomic mass region 720 and the sample 208. In particular, the low atomic mass material is desirably disposed between the high atomic mass material and the sample 208.

As shown for example in **FIGs 6-8****,** the low atomic mass region 710 may be a layer or coating of low atomic mass material on the high atomic mass region 720. Desirably, the low atomic mass region 710 may be a coating of low atomic mass material on the high atomic mass material of the high atomic mass region 720.

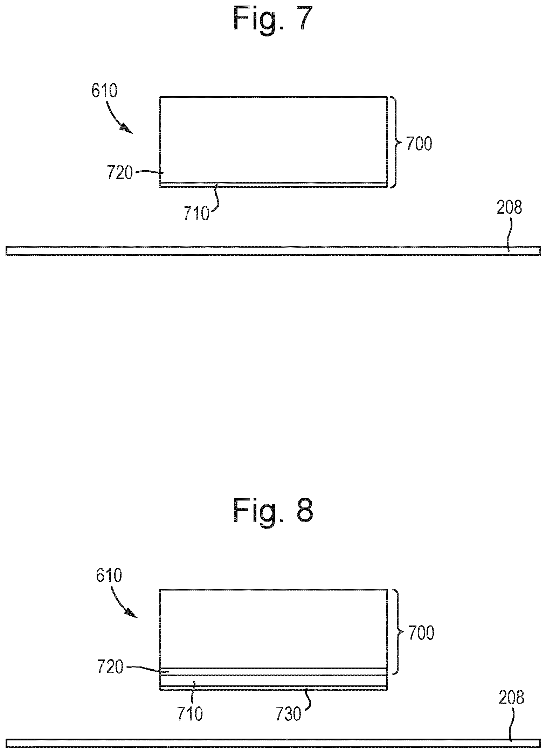

In the arrangements of **FIGs 6** **and** **8****,** the charge detector 610 comprises a current detection electrode 700. The high atomic mass region 720 is a high atomic mass coating arranged between the current detection electrode 700 and the low atomic mass region 710. The high atomic mass region is desirable arranged to limit a penetration depth of the backscattered electrons. In other words, desirably occurrences of backscattered electrons passing entirely through the charge detector 610 are lower than in an arrangement not including the high atomic mass region. In this arrangement, the current detection electrode 700 may be made of metal, desirably the current detection electrode 700 may be aluminum.

In the arrangement of **FIG. 7****,** the charge detector 610 comprises a current detection electrode 700. The current detection electrode 700 comprises the high atomic mass material. In other words, the high atomic mass region 720 is a region of the current detection electrode 700. In a preferred arrangement, the current detection electrode 700 may consist of the high atomic mass material. In other words, the current detection electrode 700 is made of the high atomic mass material. In this arrangement, the low atomic mass region 710 may be a layer or coating of low atomic mass material on the current detection electrode 700.

The low atomic mass material desirably has a thickness greater than a thickness of the high atomic mass material. The low atomic mass material may have a thickness between 600 nm and 3000 nm, desirably between 700 nm and 1800 nm, more desirably between 1000 nm and 1500 nm. Furthermore, the high atomic mass material may have a thickness between 20 nm and 500 nm, desirably between 50 nm and 300 nm, more desirably between 100 nm and 200 nm.

In one example the low atomic mass material is carbon and the high atomic mass material is tungsten. In this example, the thickness of the low atomic mass material is 800 nm and the thickness of the high atomic mass material is 50 nm. This first example has simulated backscatter electron loss of 6 % for backscatter electron energy of 15 keV. In a second example, the low atomic mass material is carbon and the high atomic mass material is tungsten. In this example, the thickness of the low atomic mass material is 300 nm and the thickness of the high atomic mass material is 1700 nm. This second example has simulated backscatter electron loss of 24 % for backscatter electron energy of 30 keV. Each simulation has been performed at a particular backscatter electron energy. It can be demonstrated that the backscatter loss electron loss will generally be lower for lower backscatter electron energy.

The low atomic mass material optionally has a secondary electron yield coefficient less than or equal to 0.5, and preferably less than or equal to 0.2, for incoming electrons with an energy of greater than or equal to 5 keV. With this arrangement, fewer second-generation interaction products may be emitted from the detector due to the low secondary electron yield coefficient of the low atomic mass material. In this way, the undesirable reduction net current measured by the detector due to second-generation interaction products may be reduced. This benefit may be particularly notable in arrangements wherein the low atomic mass region is the closest part of the charge detector 610 to the sample 208.

In an alternative arrangement, as shown for example in **FIG. 8****,** the charge detector 610 may further comprise an outer layer 730. During use, the outer layer 730 is closer to the sample 208 compared to the low atomic mass region 710. In other words, a distance between the sample 208 and the outer layer 730 is less than a distance between the sample and the low atomic mass region 710. Desirably, the outer layer 730 is disposed between the low atomic mass region 710 and the sample 208. The outer layer 730 has a secondary electron yield coefficient less than or equal to 0.5, and preferably less than or equal to 0.2, for incoming electrons with an energy of greater than or equal to 5 keV. In this way, a beneficial reduction in emission of second-generation interaction products may be achieved even if the low atomic mass material does not have a secondary electron yield coefficient in this range.

The outer layer 730 may be provided as a coating on the low atomic mass material 710. In an arrangement such as that of **FIG. 8****,** the outer layer 730 may be disposed on the low atomic mass region 710, such that the low atomic mass region 710 is between the high atomic mass region 720 and the outer layer 710. In an arrangement such as that of **FIG. 7****,** wherein the current detection electrode 700 comprises the high atomic mass material, an outer layer (not shown) may be disposed such that the low atomic mass region 710 is between the outer layer and the current detection electrode 700.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components, such as the elements 300' of the respective component, to apply potentials to the components, such as in a nonlimited list the control lens array 250, the objective lens array 241, the condenser lens 231, correctors, a collimator element array and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). For example, the aperture arrays, plate electrodes of for example the objective lens array, one more features of the detector array, scan-deflector array and collimator element array, may be formed using MEMS manufacturing techniques.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field. These references are intended to correspond with the general direction of the electron beam from source to sample. However these references with respect to the beam path may correspond to references with respect to the electron-optical axis of device 41. For a multi-device 41, the direction of the beam path least one of the sub-devices 42 (a reference sub-device) may correspond to the electron-optical axis of the same sub-device 41. The other sub-devices of the multi-device 41 may be calibrated with respect to the reference sub-device. The electron-optical axis may correspond to a geometrical axis of the reference sub-device and, in an embodiment, of the multi-device,

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical device 41 may be a component of a charged particle assessment system 40; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "beam" may be used synonymously with "sub-beam" and "beamlet". The term "manipulator" is used to encompass any element which affects the path of a sub-beam or beamlet, such as a lens or deflector.

Embodiments include the following numbered clauses:
1. An electron-beam imaging system comprising an electron-beam source for generating a primary beam, an optical system for directing and focusing the primary beam onto a sample, and a charge detector for collecting interaction products, wherein
   the charge detector comprises:
      a current detection electrode configured to connect to current measurement circuitry,
      a low atomic mass region comprising a low atomic mass material, and
      a high atomic mass region comprising a high atomic mass material,
   wherein the high atomic mass material has a higher atomic mass than the low atomic mass material,
   wherein the electron-beam imaging system is configured such that during use the low atomic mass region is closer to the sample compared to the high atomic mass region for reducing a second-generation interaction products yield at the charge detector.
2. The electron-beam imaging system of clause 1, wherein the electron-beam imaging system is configured such that during use the low atomic mass material is disposed between the high atomic mass material and the sample.
3. The electron-beam imaging system of clause 1, wherein
   the high atomic mass region is a high atomic mass coating arranged between the current detection electrode and the low atomic mass region for limiting the penetration depth of the backscattered electrons from the interaction products.
4. The electron-beam imaging system of any of the preceding clauses, wherein
   the current detection electrode comprises the high atomic mass material, and
   the high atomic mass region is a region of the current detection electrode.
5. The electron-beam imaging system of clause 4, wherein the current detection electrode consists of the high atomic mass material.
6. The electron-beam imaging system of any of the preceding clauses, wherein the low atomic mass region is a coating on the high atomic mass material.
7. The electron-beam imaging system of any of the preceding clauses, wherein the low atomic mass material has an atomic mass less than or equal to 14.
8. The electron-beam imaging system of any of the preceding clauses, wherein the high atomic mass material has an atomic mass greater than or equal to 21.
9. The electron-beam imaging system of any of the preceding clauses, wherein the low atomic mass material has a thickness greater than a thickness of the high atomic mass material.
10. The electron-beam imaging system of any of the preceding clauses, wherein the low atomic mass material has a thickness between 600 nm and 3000 nm.
11. The electron-beam imaging system of any of the preceding clauses, wherein the high atomic mass material has a thickness between 20 nm and 500 nm.
12. The electron-beam imaging system of any of the preceding clauses, wherein the low atomic mass material has a secondary electron yield coefficient less than or equal to 0.5 for incoming electrons with an energy of greater than or equal to 5 keV.
13. The electron-beam imaging system of any of the preceding clauses, wherein the charge detector further comprises an outer layer, wherein the outer layer is closer to the sample compared to the low atomic mass region, and the outer layer has a secondary electron yield coefficient less than or equal to 0.5 for incoming electrons with an energy of greater than or equal to 5 keV.
14. The electron-beam imaging system of clause 13, wherein the outer layer is disposed on the low atomic mass region, such that the low atomic mass region is between the high atomic mass region and the outer layer.
15. The electron-beam imaging system of clause 14, wherein the outer layer is a coating on the low atomic mass material.
16. The electron-beam imaging system of any of the preceding clauses, wherein the electron-beam imaging system is configured to create an electric field to repel secondary electrons of the interaction products from the charge detector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. An electron-beam imaging system comprising an electron-beam source for generating a primary beam, an optical system for directing and focusing the primary beam onto a sample, and a charge detector for collecting interaction products, wherein
the charge detector comprises:
a current detection electrode configured to connect to current measurement circuitry,
a low atomic mass region comprising a low atomic mass material, and
a high atomic mass region comprising a high atomic mass material,
wherein the high atomic mass material has a higher atomic mass than the low atomic mass material,
wherein the electron-beam imaging system is configured such that during use the low atomic mass region is closer to the sample compared to the high atomic mass region for reducing a second-generation interaction products yield at the charge detector.

2. The electron-beam imaging system of claim 1, wherein the electron-beam imaging system is configured such that during use the low atomic mass material is disposed between the high atomic mass material and the sample.

3. The electron-beam imaging system of claim 1, wherein
the high atomic mass region is a high atomic mass coating arranged between the current detection electrode and the low atomic mass region for limiting the penetration depth of the backscattered electrons from the interaction products.

4. The electron-beam imaging system of claim 1, wherein
the current detection electrode comprises the high atomic mass material, and
the high atomic mass region is a region of the current detection electrode.

5. The electron-beam imaging system of claim 4, wherein the current detection electrode consists of the high atomic mass material.

6. The electron-beam imaging system of claim 1, wherein the low atomic mass region is a coating on the high atomic mass material.

7. The electron-beam imaging system of claim 1, wherein the low atomic mass material has an atomic mass less than or equal to 14, and/or wherein the high atomic mass material has an atomic mass greater than or equal to 21.

8. The electron-beam imaging system of claim 1, wherein the low atomic mass material has a thickness greater than a thickness of the high atomic mass material.

9. The electron-beam imaging system of claim 1, wherein the low atomic mass material has a thickness between 600 nm and 3000 nm.

10. The electron-beam imaging system of claim 1, wherein the high atomic mass material has a thickness between 20 nm and 500 nm.

11. The electron-beam imaging system of claim 1, wherein the low atomic mass material has a secondary electron yield coefficient less than or equal to 0.5 for incoming electrons with an energy of greater than or equal to 5 keV.

12. The electron-beam imaging system of claim 1, wherein the charge detector further comprises an outer layer, wherein the outer layer is closer to the sample compared to the low atomic mass region, and the outer layer has a secondary electron yield coefficient less than or equal to 0.5 for incoming electrons with an energy of greater than or equal to 5 keV.

13. The electron-beam imaging system of claim 12, wherein the outer layer is disposed on the low atomic mass region, such that the low atomic mass region is between the high atomic mass region and the outer layer.

14. The electron-beam imaging system of claim 13, wherein the outer layer is a coating on the low atomic mass material.

15. The electron-beam imaging system of claim 1, wherein the electron-beam imaging system is configured to create an electric field to repel secondary electrons of the interaction products from the charge detector.
